# EUROPEAN PATENT APPLICATION

(11) **EP 4 582 467 A1**
(43) Date of publication of application: **09.07.2025**
(21) Application number: 23859141.6
(22) Date of filing: 14.08.2023
(51) Int. Cl.: C08G 83/00, G03F 7/004, G03F 7/20, G03F 7/00, G03F 1/76

(54) **ZN-BASED ORGANICALLY-COORDINATED NANOPARTICLES, PHOTORESIST COMPOSITION, PREPARATION METHOD THEREFOR, AND USE THEREOF**

(30) Priority: 29.08.2022 CN 202211050526
(71) Applicant: Tsinghua University, Beijing 100084 (CN); Beijing Vfortune New Energy Power Technology Development Co., Ltd., Beijing 100089 (CN)
(72) Inventor: XU, Hong, Beijing 100084 (CN); HE, Xiangming, Beijing 100084 (CN); TAO, Peipei, Beijing 100084 (CN)
(74) Representative: Lavoix
(86) International application number: PCT/CN2023/112964
(87) International publication number: WO 2024/046107

(57) **Abstract**

The present invention relates to Zn-based organically-coordinated nanoparticles, a photoresist composition, a preparation method therefor, and the use thereof. The nanoparticles have a metal-organic one-dimensional repeatedly-arranged chain structure, the structural general formula being [ZnX₂(CH₃COO)Y]ₙ, X being selected from benzoate or m-methylbenzoate, Y being selected from organic amine ligands, n being the degree of polymerization, and n being greater than or equal to 1. The Zn-based organically-coordinated nanoparticles can be used for forming a photoresist composition, which can be used for middle-ultraviolet, electron beam, and extreme-ultraviolet lithography so as to obtain high-quality exposure patterns. Therefore, the Zn-based organically-coordinated nanoparticles of the present invention have remarkable potential and value in use.

## Description

### TECHNICAL FIELD

The invention relates to the technical field of photoresist, and in particular to a Zn-based organically-coordinated nanoparticle, a photoresist composition, and a preparation method therefor and use thereof.

### BACKGROUND

Lithography refers to the technology of transferring the pattern on the mask to the substrate through a photoresist under certain energy, which is the essence of chip manufacturing. In the process of integrated circuit manufacturing, the cost of lithography makes up one-third or even more of the total cost; the size and quality of the lithography largely affect the performance of the chip. With the continuous development of the lithography technology, the line width of the light source continues to decrease, and the exposure technology using a light source of 13.5nm Extreme Ultra-Violet has gradually become the main choice for lithography nodes below 7 nm.

Photoresist is a photosensitive material, whose main function is to transfer the pattern of the chip design from the mask to the substrate. In this process, the photoresist undergoes chemical reactions under the irradiation of light, causing change in the dissolution rate. As the exposure wavelength in the lithography process continues to decrease, the corresponding photoresist materials also change accordingly. According to the different photosensitivity wavelengths, photoresists can be divided into photoresists for G-line, photoresists for I-line, photoresists for 248nm, photoresists for 193nm and photoresists for 13.5nm Extreme Ultra-Violet (EUV).

The power and conversion efficiency of the light source of Extreme Ultra-Violet lithography are low. Therefore, organic polymer photoresists and molecular glass photoresists based on the major elements such as C and O are no longer applicable due to their low photon absorption rate and low sensitivity. In order to improve the photon absorption rate of photoresists, metal elements with a higher optical absorption cross section are introduced. In recent years, the research on metal-organic photoresists has been deepened continuously. The photoresist containing a zirconium oxide nanoparticle developed by Ober of Cornell University and Brainard Lab of State University of New York has achieved an ultra-high sensitivity of 4.2 mJ/cm² and a line width resolution of 26 nm. However, the size distribution of the nanoparticle produced by a gel sol method is relatively wide, resulting in difference in dissolution rates during organic development, hereby creating a line edge roughness of 5.9 nm. In 2009, Inpria's patent application WO2009/120169A also prepared a photoresist mixture of the metal oxides HfO₂+ or ZrO₂+ with organic ligands. After coating, exposure and development, the composition can obtain a pattern with an LER of 2.25nm and an interval of no more than 60nm. Subsequently, Inpria also developed a composition comprising Sn-based metal oxides and organic ligands, and organically-inorganic nanoclusters, and confirmed their feasibility as EUV photoresists (TW1719360B, TW201943724A, TW202110863A, WO2019195522A). However, due to the toxicity of the Sn element per se, it is difficult to avoid the toxicity of the Sn-based organically-coordinated photoresist composition. Therefore, the Sn-based organically-coordinated photoresist composition still confronts with the risk of process safety, which also restricts its industrial application and promotion.

In order to further obtain safer and more reliable metal organically-coordinated photoresists, the Zn element system becomes a potential choice. The present invention aims to develop a new Zn-based organically-coordinated photoresist with lower roughness, higher resolution, wider applicability, safety and greenness.

### SUMMARY

### Technical Problem

Based on this, it is necessary to propose a new Zn-based organically-coordinated nanoparticle, a photoresist composition, and a preparation method therefor and use thereof, to address the problems of large edge roughness and low resolution of patterns obtained by lithography of traditional photoresists.

### Technical Solution

First, the present invention provides a Zn-based organically-coordinated nanoparticle, which is a metal-organic one-dimensional repeatedly-arranged chain structure with a structural general formula of [ZnX₂(CH₃COO)Y]ₙ, wherein X is selected from benzoate or m-methylbenzoate, Y is selected from organic amine ligands, and n is a degree of polymerization, which is greater than or equal to 1. The size of the prepared Zn-based organically-coordinated nanoparticle is from 1nm to 4 nm.

Furthermore, the organic amine ligand is selected from N-methylpiperidine, N-methylpyrrolidine, cyclohexylimine, and methylpyrrolidine.

The present invention also provides a method for preparing a Zn-based organically-coordinated nanoparticle, comprising the following steps:
(1) mixing a metallic zinc salt with an organic solvent to obtain a solution containing the metallic zinc salt;
(2) mixing the solution containing the metallic zinc salt with a first organic ligand and a second organic ligand, and heating and stirring the mixture to perform reaction therebetween;
(3) removing the residual solvent in the product after the reaction.

Further, the first organic ligand is benzoic acid or m-methylbenzoic acid, and the second organic ligand is selected from N-methylpiperidine, N-methylpyrrolidine, cyclohexylimine, and methylpyrrolidine.

The molar ratio of the metallic zinc salt, the first organic ligand, and the second organic ligand is (0.2~1):(0.4~1):(0.3~1); preferably, the molar ratio of the metallic zinc salt, the first organic ligand, and the second organic ligand is 1:(3-5):(2-5).

Further, in step (2), the temperature range of the heating and stirring is from 50°C to 80°C, and the period thereof is from 10h to 40h.

Further, in step (3), the method for removing the solvent may be vacuum rotary evaporation, in which the temperature is from 20°C to 80°C, the pressure of the vacuum rotary evaporation may be from 20mbar to 60mbar, and the period of the vacuum rotary evaporation may be from 30 min to 60 min.

The present invention also provides a Zn-based organically-coordinated nanoparticle obtained by the above-mentioned preparation method.

The present invention also provides a photoresist composition containing a Zn-based organically-coordinated nanoparticle, which comprises the above-mentioned Zn-based organically-coordinated nanoparticle, a photoacid agent and an organic dispersing solvent, the mass percentage of the Zn-based organically-coordinated nanoparticle is 3%-20%, and the mass percentage of the photoacid agent is 5%-10%.

The photoacid agent may be any one or more selected from of N-hydroxynaphthalimide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid; the organic dispersing solvent may be any one or more selected from ethyl acetate, butyl acetate, propylene glycol monoethyl ether acetate, propylene glycol methyl ether acetate, 1-ethoxy-2-propanol, methanol, ethanol and propanol.

Further, a method for preparing the above-mentioned photoresist composition containing a Zn-based organically-coordinated nanoparticle specifically comprises: dissolving the obtained nanoparticle composition with an organic dispersing solvent, adding a photoacid agent thereto, stirring the mixture for 5 min until dissolved completely, and obtaining a mixed photoresist solution.

The present invention further provides a method for patterning a photoresist, comprising the following steps:
(1) coating the above-mentioned photoresist composition on the surface of a substrate, removing the organic dispersing solvent, and forming a pre-film layer on the surface of the substrate;
(2) irradiating the pre-film layer of the substrate with a light source through a mask to perform exposure operation, so that the exposed area of the pre-film layer forms agglomerates of the photoresist particle;
(3) applying a developing agent to the pre-film layer after exposure, so that the unexposed area of the pre-film layer blocked by the mask is dissolved in the developing agent, and the exposed area of the pre-film layer is retained on the substrate due to forming agglomerates of the photoresist particles.

Specifically, the exposure condition may be any one selected from Mid-Ultra-Violet, electron beam and Extreme Ultra-Violet, the exposure dose for ultraviolet is 50mJ/cm²~500mJ/cm², the exposure dose for electron beam is 50µC/cm²-500µC/cm², and the thickness of the pre-film layer after removing the organic dispersing solvent may be 10nm~100nm.

The Zn-based organically-coordinated nanoparticle and the photoresist composition thereof of the present invention may be used to form a printed circuit board. The specific method comprises the following steps:
(1) preparing a pre-patterned sheet having a patterned photoresist layer on a silicon substrate according to the above-mentioned photoresist patterning method;
(2) etching the pre-patterned sheet by dry or wet etching.

### Beneficial Effects

The Zn-based organically-coordinated nanoparticle designed and prepared by the present invention has a metal-organic one-dimensional repeatedly-arranged chain structure. Under the condition of illumination, the Zn-based organically-coordinated nanoparticle may interact with a photoacid agent, the polarity of the material changes, and aggregation occurs, resulting in change in the solubility of the Zn-based organically-coordinated nanoparticle before and after illumination. Due to these characteristics, the coordinated polymer nanoparticle is used as a photoresist component to make the solubility of the photosensitive part and the light-shielding part of the photoresist in the developing agent different. The photosensitive part is aggregated in the developing agent and the solubility is reduced, while the light-shielding part is not aggregated and dissolved in the developing agent, so that the non-exposed area can be reshifted after development to obtain a pattern of a desired shape.

In particular, due to the special structure of the Zn-based organically-coordinated nanoparticle, compared with traditional polymer photoresists and molecular glass photoresists, the Zn-based organically-coordinated nanoparticle of the present invention is used as a photoresist component to achieve better lithography performance such as high resolution, high sensitivity, and low line roughness. At present, the integrated circuit processes using domestic photoresists are mostly above 350nm, while ArF photoresists used for 193nm are still in the primary stage, and advanced ArF photoresists are substantively dependent on imports. Therefore, when the Zn-based organically-coordinated nanoparticle provided by the present invention is used as photoresist materials for lithography, better pattern resolution can be achieved with respect to the prior art, which is a major step forward in the indigenization of photoresists.

Further, the coordinated polymer nanoparticle of the present invention as a photoresist component may be used for pattern generating under various exposure conditions such as Mid-Ultra-Violet, electron beam, Extreme Ultra-Violet, etc., and may also achieve extremely high photosensitivity and resolution. Moreover, compared with polymer photoresists and molecular glass photoresists, the presence of metal elements makes the photoresist of the present invention have better etching resistance.

### BRIEF DESCRIPTION OF THE DRAWINGS

FIG. 1 is a particle size distribution curve of the product prepared in Example 1 measured by dynamic light scattering particle size test (DLS).
FIG. 2 is the basic structural unit of the product prepared in Example 1.
FIG. 3 is the one-dimensional repeatedly-arranged chain structure of the product prepared in Example 1.
FIG. 4 is the exposure pattern obtained after the photoresist prepared in Example 1 was exposed to Mid-Ultra-Violet light.
FIG. 5 is the exposure pattern obtained after the photoresist prepared in Example 1 was exposed to electron beam.
FIG. 6 is the particle size distribution curve of the product prepared in Example 2 measured by the dynamic light scattering particle size test (DLS).
FIG. 7 shows the Hydrogen Nuclear Magnetic Resonance (H NMR) spectrums of the product prepared in Example 2 and the fed raw materials thereof.
FIG. 8 shows the basic structural unit of the product prepared in Example 2.
FIG. 9 shows the one-dimensional repeatedly-arranged chain structure of the product prepared in Example 2.
FIG. 10 shows the exposure pattern obtained after the photoresist prepared in Example 2 was exposed to Mid-Ultra-Violet light.
FIG. 11 shows the exposure pattern obtained after the photoresist prepared in Example 2 was exposed to electron beam.
FIG. 12 shows the particle size distribution curve of the product prepared in Example 3 measured by the dynamic light scattering particle size test (DLS).
FIG. 13 shows the H NMR spectrums of the product prepared in Example 3 and the fed raw materials thereof.
FIG. 14 shows the basic structural unit of the product prepared in Example 3.
FIG. 15 shows the one-dimensional repeatedly-arranged chain structure of the product prepared in Example 3.
FIG. 16 shows the exposure pattern obtained after the photoresist prepared in Example 3 was exposed to Mid-Ultra-Violet light.
FIG. 17 shows the exposure pattern obtained after the photoresist prepared in Example 3 was exposed to electron beam.
FIG. 18 shows the particle size distribution curve of the product prepared in Example 4 measured by the dynamic light scattering particle size test (DLS).
FIG. 19 is the H NMR spectrums of the product prepared in Example 4 and the fed raw materials thereof.
FIG. 20 is the exposure pattern obtained after the photoresist prepared in Example 4 was exposed to Mid-Ultra-Violet.
FIG. 21 is the exposure pattern obtained after the photoresist prepared in Example 4 was exposed to electron beam.
FIG. 22 is the particle size distribution curve of the product prepared in Example 5 measured by the dynamic light scattering particle size test (DLS).
FIG. 23 is the H NMR spectrums of the product prepared in Example 5 and the fed raw materials thereof.
FIG. 24 is the basic structural unit of the product prepared in Example 5.
FIG. 25 is the one-dimensional repeatedly-arranged chain structure of the product prepared in Example 5.
FIG. 26 is the exposure pattern obtained after the photoresist prepared in Example 5 was exposed to Mid-Ultra-Violet.
FIG. 27 is the exposure pattern obtained after the photoresist prepared in Example 5 was exposed to electron beam.

### DETAILED DESCRIPTION OF THE PREFERRED EMBODIMENTS

### Embodiments of the present invention

In order to facilitate the understanding of the present invention, the present invention will be described more fully below with reference to the relevant drawings. The preferred embodiments of the present invention are shown in the drawings. However, the present invention can be implemented in many different forms and is not limited to the embodiments described herein. On the contrary, the purpose of providing these embodiments is to make the understanding of the disclosure of the present invention more thorough and comprehensive.

Unless otherwise defined, all technical and scientific terms used herein have the same meaning as those generally understood by the technicians in the technical field of the present invention. The terms used in the specification of the present invention herein are only for the purpose of describing specific embodiments and are not intended to limit the present invention.

The following are specific embodiments, which are intended to further explain the present invention in detail to help those skilled in the art and researchers further understand the present invention. The relevant technical conditions do not constitute any limitation to the present invention. Any form of modification made within the scope of the claims of the present invention is within the protection scope claimed in the present invention.

The present invention provides a Zn-based organically-coordinated nanoparticle with a chemical formula of [ZnX₂(CH₃COO)Y]ₙ, wherein X is a ligand selected from benzoic acid or m-methylbenzoic acid, Y is selected from N-methylpiperidine, N-methylpyrrolidine, cyclohexylimine, methylpyrrolidine, n is a degree of polymerization and is greater than or equal to 1, and as the n value increases, the nanoparticle is a metal-organic one-dimensional repeatedly-arranged chain structure. Further, the size of the nanoparticle is from 1 nm to 4 nm.

The present invention also provides a method for preparing a Zn-based organically-coordinated nanoparticle, comprising the following steps:
(1) mixing a metallic zinc salt with an organic solvent to obtain a solution containing the metallic zinc salt;
(2) mixing the solution containing the metallic zinc salt with a first organic ligand and a second organic ligand, and heating and stirring the mixture to perform reaction therebetween;
(3) removing the residual solvent in the product after the reaction;
wherein the first organic ligand is benzoic acid or m-methylbenzoic acid, and the second organic ligand is selected from N-methylpiperidine, N-methylpyrrolidine, cyclohexylimine, and methylpyrrolidine.

Further, the molar ratio of the metallic zinc salt, the first organic ligand and the second organic ligand is (0.2~1):(0.4~1):(0.3~1);
Further, in the preferred embodiment, the molar ratio of the metallic zinc salt, the first organic ligand and the second organic ligand is within the range of 1:(3~5):(2~5), and a Zn-based organically-coordinated nanoparticle can be obtained.

Further, in step (2), the temperature range of the heating and stirring is from 50°C to 80°C, and the period is from 10h to 40h. When the temperature is too low, the reaction speed will be too slow. When the temperature is too high, the reaction will be unstable and a Zn-based organically-coordinated nanoparticle cannot be obtained.

Further, in step (3), the method for removing the solvent may be any conventional method in the art, such as vacuum rotary evaporation; specifically, the temperature during the vacuum rotary evaporation may be from 20°C to 80°C, for example, it may also be selected from 25°C, 30°C, 35°C, 40°C, 45°C, 50°C, 55°C, 60°C, 65°C, 70°C, 75°C. During the process of the vacuum rotary evaporation, when the temperature is too low, the reaction speed will be too slow. If the temperature is too high, the properties of the coordinated polymer nanoparticle will be unstable under vacuum and the groups will be easily destroyed; the pressure of the vacuum rotary evaporation may be any value between 20mbar and 60mbar. For example, it may also be 25 mbar, 30 mbar, 35 mbar, 40 mbar, 45 mbar, 50 mbar or 55 mbar. The period of the vacuum rotary evaporation may be any value between 30 min and 60 min, for example, it may also be 35 min, 40 min, 45 min, 50 min or 55 min.

The present invention also provides a photoresist composition containing a Zn-based organically-coordinated nanoparticle, which comprises the Zn-based organically-coordinated nanoparticle prepared above, a photoacid agent and an organic dispersing solvent. Wherein the mass percentage of the Zn-based organically-coordinated nanoparticle is 3%-20%, and the mass percentage of the photoacid agent may be 5%-10%.

The photoacid agent may be any one or more selected from N-hydroxynaphthalene imide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid. The organic dispersing solvent may be any one or more selected from ethyl acetate, butyl acetate, propylene glycol monoethyl ether acetate, propylene glycol methyl ether acetate, 1-ethoxy-2-propanol, methanol, ethanol, and propanol.

Furthermore, the preparation process of the photoresist composition containing a Zn-based organically-coordinated nanoparticle is to dissolve the obtained nanoparticle with an organic dispersing solvent, then add a photoacid agent thereto, stir the mixture for 5 min until dissolved completely to obtain a mixed photoresist solution.

An embodiment of the present invention also provides a method for patterning a photoresist, comprising the following steps:
(1) coating the photoresist composition on the surface of a substrate, removing the organic dispersing solvent, and forming a pre-film layer on the surface of the substrate;
(2) irradiating the pre-film layer of the substrate through a mask using a light source to perform exposure operation, so that the exposed area of the pre-film layer forms agglomerates of photoresist particles;
(3) applying a developing agent to the pre-film layer after exposure, so that the unexposed area of the pre-film layer blocked by the mask is dissolved in the developing agent, and the exposed area of the pre-film layer is retained on the substrate due to forming agglomerates of the photoresist particles.

In step (2), the exposure condition may be any one selected from Mid-Ultra-Violet, electron beam, and Extreme Ultra-Violet. Further, regarding the mask, transmissive masks may be used for the light sources of Deep Ultra-Violet and longer wavelength, reflective masks may be used for the light sources of Extreme Ultra-Violet, and electron beam may be used for exposure according to the pattern set by the software. The substrate is selected from a silicon sheet, and other substrates insoluble in the developing agent may also be selected according to actual needs.

Furthermore, the exposure dose of the exposure operation is from 50mJ/cm² to 500mJ/cm². The exposure dose should be controlled within an appropriate range. If the exposure dose is too small, the energy will be too low, which is not conducive to the polymerization of the photoresist particles in the exposed area, and is not conducive to the formation of the difference in solubility between the exposed area and the non-exposed area, resulting in poor development effect. Compared with bare metal nanoparticles, the polymerization of nanoparticles containing organic ligands is easier to proceed. If the exposure dose is too large, the organic ligands may detach directly from the metal oxide to form fragments, and the photoresist particles can no longer undergo an exchange reaction of the organic ligands, thereby reducing the degree of polymerization in the exposed area.

In step (3), the developing agent is any one or any mixture of more selected from decalin, tetralin, indene, indane, quinoline, 1-methylnaphthalene, toluene, o-xylene, m-xylene, p-xylene, ethyl acetate, butyl acetate, ethanol, n-propanol, isopropanol, n-butanol, n-hexane and cyclohexane. In some embodiments, the development temperature may be room temperature, for example, from 20°C to 50°C.

The developing agent is mainly used to dissolve unagglomerated and coordinated polymer nanoparticles. The organic ligands in the coordinated polymer nanoparticles in the exposed area interact with the ligands produced by the photoacid agent, and the polarity changes, and aggregation occurs to form agglomerates. The agglomerates in the exposed area are not dissolved in the developing agent or the solubility of the agglomerates in the exposed area is small in the developing agent, and even if partially dissolved, the exposed area can still be covered by the agglomerates. The developing agent and the organic dispersing solvent in the photoresist composition may be the same or different. Preferably, the solubility of the coordinated polymer in the developing agent is less than the solubility in the organic dispersing solvent, so as to avoid the coordinated polymer from being dissolved in the developing agent due to insufficient polymerization degree after exposure, so that the exposed area is dissolved or partially dissolved, resulting in inaccurate exposure pattern.

In step (3), the thickness of the pre-filmed layer after removing the organic dispersing solvent may be from 10 nm to 100 nm. Specifically, the thickness of the pre-filmed layer may be from 10 nm to 20 nm, from 20 nm to 30 nm, from 30 nm to 40 nm, from 40 nm to 50 nm, from 50 nm to 60 nm, from 60 nm to 70 nm, from 70 nm to 80 nm, from 80 nm to 90 nm, or from 90 nm to 100 nm.

The present invention also provides a method for forming a printed circuit board, comprising the following steps: (1) preparing a pre-patterned sheet having a patterned photoresist layer on a silicon substrate according to the photoresist patterning method; (2) etching the pre-patterned sheet by dry or wet etching.

The following is described in detail with reference to specific examples:

### Example 1

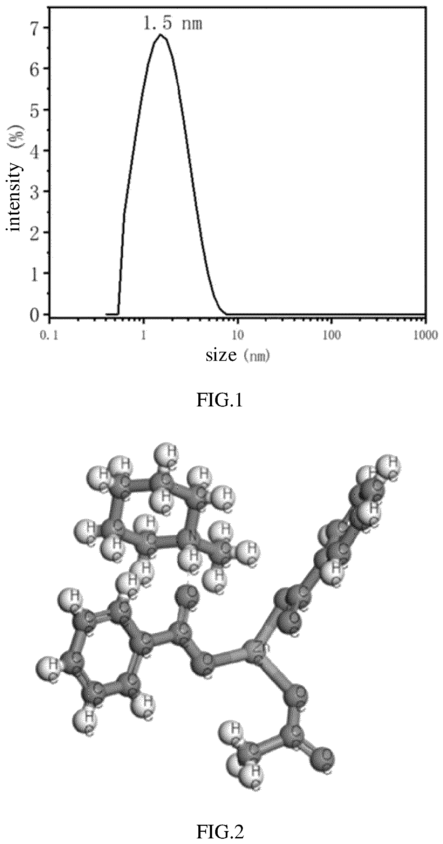

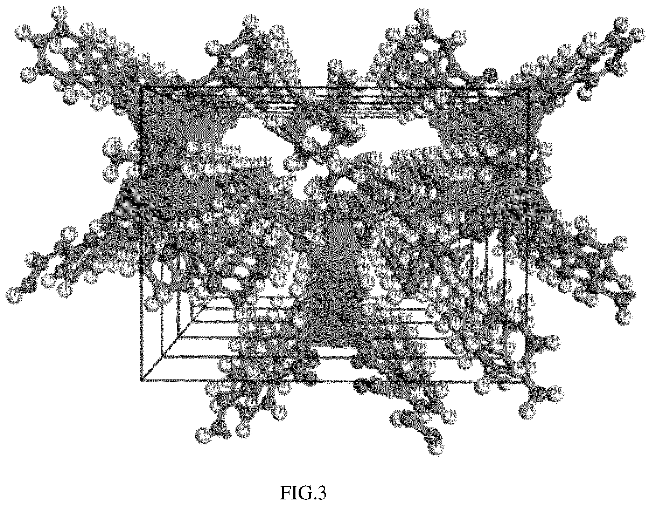

1) Preparation of a Zn-based organically-coordinated nanoparticle: 4.396g (36 mmol) benzoic acid and 2.678g (27 mmol) N-methylpiperidine were added to a flask and mixed, 15mL ethyl acetate was added, and the mixture was dissolved for 5min. The resulting solution was defined as A. 3.951g (18 mmol) zinc acetate dihydrate was added to a flask, and 30 mL ethyl acetate was added. The resulting solution was defined as B. Solution A was added dropwise to solution B in the flask and stirred at 65°C for 16 h. After the reaction was completed, a rotary evaporator was used to evaporate at 50°C for 40 min, and the pressure was controlled to be 40 mbar to obtain the synthesized product. An appropriate amount of the product was taken for the dynamic light scattering particle size test (DLS), and the particle size distribution curve of the product was measured (as shown in FIG. 1). As can be seen from FIG. 1, the average particle size of the suspended particles in the synthesized product is 1.5nm, and the particle size distribution range is narrow, indicating that the particle size consistency of the nanoparticles is good. Furthermore, the structural composition of the synthesized product was determined. FIG. 2 shows the basic structural unit of the synthesized product, and the structural formula of this basic structural unit is Zn(C₆H₅COO)₂(CH₃COO)(CH₃C₅H₁₀N)H. FIG. 3 shows a one-dimensional repeatedly-arranged chain structure formed by polymerization of the basic structural unit, whose structure is [Zn(C₆H₅COO)₂(CH₃COO)(CH₃C₅H₁₀N)H]ₙ.
(2) Preparation of a photoresist composition comprising the Zn-based organically-coordinated nanoparticle: 0.5g the above-prepared Zn-based organically-coordinated nanoparticle was taken, 0.05g N-hydroxynaphthaleneimide trifluoromethanesulfonic acid was selected, the Zn-based organically-coordinated nanoparticle and N-hydroxynaphthaleneimide trifluoromethanesulfonic acid were dissolved in 9.45g propylene glycol monomethyl ether acetate to prepare the photoresist composition comprising the Zn-based organically-coordinated nanoparticle.
(3) Preparation of a photoresist coating containing the Zn-based organically-coordinated nanoparticle: the photoresist solution containing the Zn-based organically-coordinated nanoparticle prepared in step (2) was applied onto a 2-inch silicon wafer at a rotating speed of 2000 rpm for 1 min, and then the wafer was baked at 80°C for 1 min to obtain a pre-film layer of the photoresist containing the Zn-based organically-coordinated nanoparticle, whose thickness was 30nm.
(4) Exposure of the photoresist coating containing the Zn-based organically-coordinated nanoparticle: Exposure was performed under 254 nm Mid-Ultra-Violet light, and the exposure operation was performed by using the light source to irradiate through the mask on the pre-filmed layer of the substrate, so that agglomerates of the photoresist particles were formed in the exposed area of the pre-film layer. The substrate was selected from a silicon sheet, and the exposure dose of the exposure operation was 150mJ/cm². Alternatively, the exposure was performed under electron beam, and the exposure dose of the exposure operation was 190µC/cm².
(5) Development: Decalin was selected as a developing agent and applied to the pre-film layer after exposure, so that the unexposed area of the pre-film layer blocked by the mask was dissolved in the developing agent, while the exposed area of the pre-film layer was retained on the substrate due to the formation of photoresist particle agglomerates. The development temperature is room temperature of 26°C.

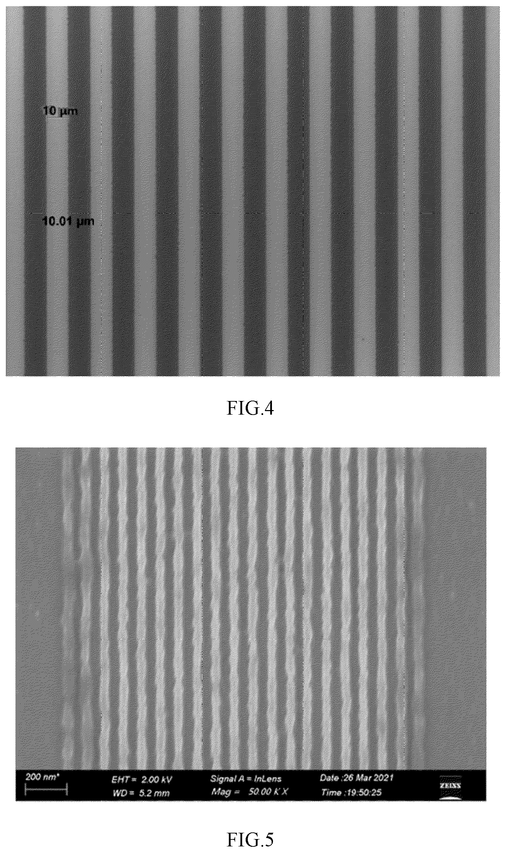

FIG. 4 shows the exposure pattern of the photoresist prepared in this example after exposure under Mid-Ultra-Violet light. It can be seen that the exposure line width is 10µm, the exposure pattern lines are clear, and the edge roughness is low, which fully meets the requirements of Mid-Ultra-Violet lithography and has higher exposure quality than the traditional CAR system. FIG. 5 shows the exposure lines with a line width of 50nm obtained by the photoresist prepared with the Zn-based organically-coordinated nanoparticle after exposure under electron beam. It can be seen from the figure that the lithography pattern lines are very clear and can meet the requirements of 50nm exposure pattern, and the photoresist can be used as an electron beam photoresist.

### Example 2

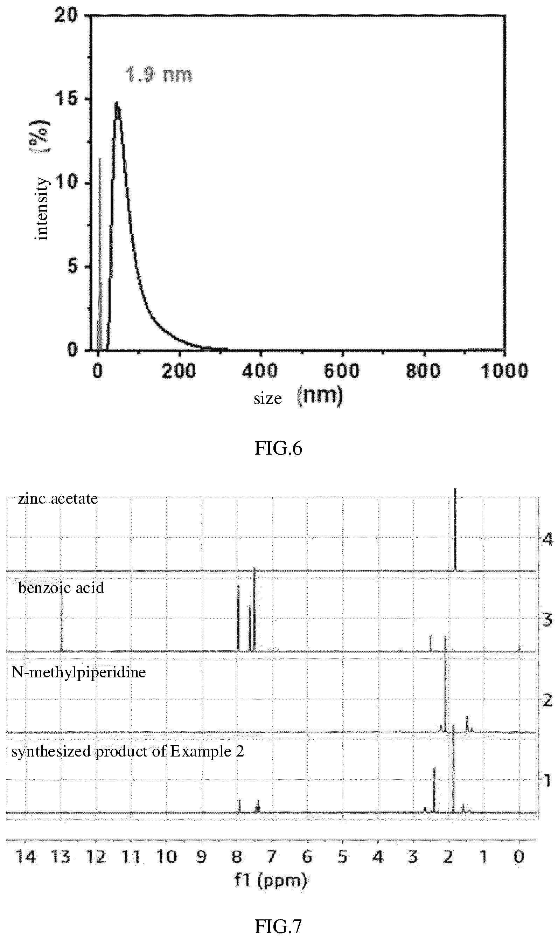

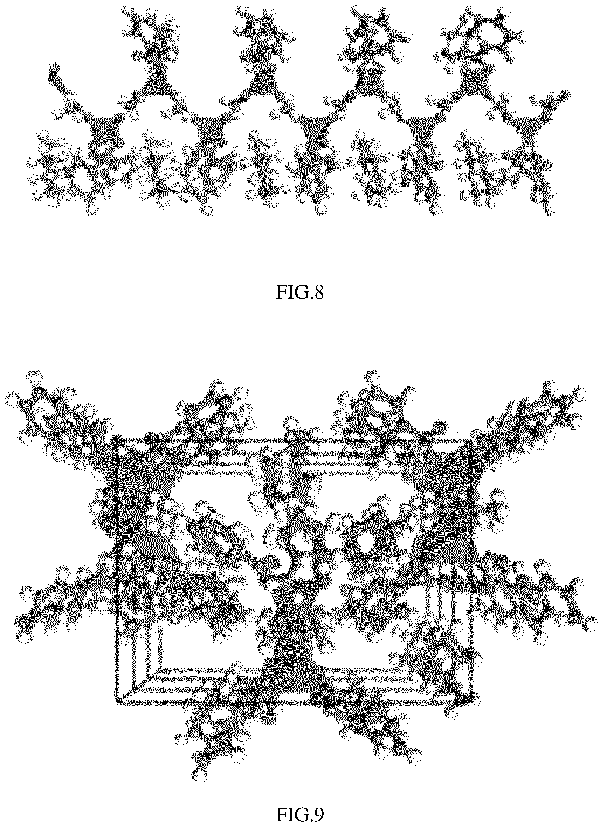

(1) Preparation of a Zn-based organically-coordinated nanoparticle: 4.396 g (36 mmol) of benzoic acid and 2.299 g (27 mmol) of N-methylpyrrolidine were added to a flask and mixed, then 15 mL of ethyl acetate was added thereto, and the mixture were mixed and dissolved for 5 min. The resulting solution was defined as A. 3.951 g (18 mmol) of zinc acetate dihydrate was added to a flask and 30 mL of ethyl acetate was added. The resulting solution was defined as B. Solution A was added dropwise to solution B in the flask and stirred at 65 °C for 16 h. After the reaction was completed, a rotary evaporator was used to rotate and evaporate at 50 °C for 40 min and the pressure was controlled at 40 mbar to obtain the synthesized product. An appropriate amount of the product was taken for the dynamic light scattering particle size test (DLS), hereby resulting in the particle size distribution curve of the product particles (as shown in FIG. 6). As can be seen from FIG. 6, the average particle size of the suspended particles in the synthesized product is 1.9nm, and the particle size distribution range is narrow, and the particle size consistency of the nanoparticles is good. The prepared nanoparticle was tested by nuclear magnetic resonance, and the hydrogen nuclear magnetic spectrum data (see FIG. 7) are: ¹H NMR (400 MHz, DMSO-d₆) δ 7.97 - 7.89 (m), 7.51 - 7.35 (m), 2.68 (d, *J =* 6.9 Hz), 2.41 (s), 1.86 (s), 1.59 (p, J = 5.7 Hz), 1.45 - 1.36 (m); the peaks in the N-methylpiperidine structure shifted from 1.34, 1.47, 2.10, and 2.22 to 1.40, 1.59, 2.41, and 2.68, respectively; the peak of the methyl group in zinc acetate shifted from 1.82 to 1.86; the peak of the benzene ring in benzoic acid also shifted from 7.51, 7.63, and 7.95 to 7.39, 7.47, and 7.93. In the prepared nanoparticles, each monomer was coordinated separately. After calculation, the basic structural unit of the prepared nanoparticles was Zn(C₆H₅COO)₂(CH₃COO)(CH₃C₄H₈N) (as shown in FIG. 8), and the formed nanoorganic structure of one-dimensional repeatedly-arranged chain was [Zn(C₆H₅COO)₂(CH₃COO)(CH₃C₄H₈N)]ₙ as shown in FIG. 9.
(2) Preparation of a photoresist composition containing a Zn-based organically-coordinated nanoparticle: 0.5g the above-prepared Zn-based organically-coordinated nanoparticle was taken, 0.05g N-hydroxynaphthaleneimide trifluoromethanesulfonic acid was selected, the Zn-based organically-coordinated nanoparticle and N-hydroxynaphthaleneimide trifluoromethanesulfonic acid were dissolved in 9.45g propylene glycol monomethyl ether acetate to prepare the photoresist composition containing the Zn-based organically-coordinated nanoparticle.
(3) Preparation of a photoresist coating containing a Zn-based organically-coordinated nanoparticle: the photoresist solution containing the Zn-based organically-coordinated nanoparticle prepared in step (2) was taken, and was applied on a 2-inch silicon wafer at a rotating speed of 2000 rpm for 1 min, and then the wafer was baked at 80°C for 1 min to obtain a pre-film layer of the photoresist containing the Zn-based organically-coordinated nanoparticle. The thickness of the pre-film layer was 30nm.
(4) Exposure of a photoresist coating containing a Zn-based organically-coordinated nanoparticle: exposure was performed under 254 nm Mid-Ultra-Violet light, and exposure operation was performed by irradiating the pre-filmed layer of the substrate with the light source through a mask, so that photoresist particle agglomerates were formed in the exposed area of the pre-filmed layer. The substrate was selected from a silicon sheet, and the exposure dose of the exposure operation was 150 mJ/cm². Alternatively, exposure was performed under electron beam, and the exposure dose of the exposure operation was 190 µC/cm².
(5) Development: Decalin was selected as a developing agent and applied to the pre-filmed layer after exposure, so that the unexposed area of the pre-filmed layer blocked by the mask was dissolved in the developing agent, while the exposed area of the pre-filmed layer was retained on the substrate due to the formation of photoresist particle agglomerates. The development temperature was room temperature 26°C.

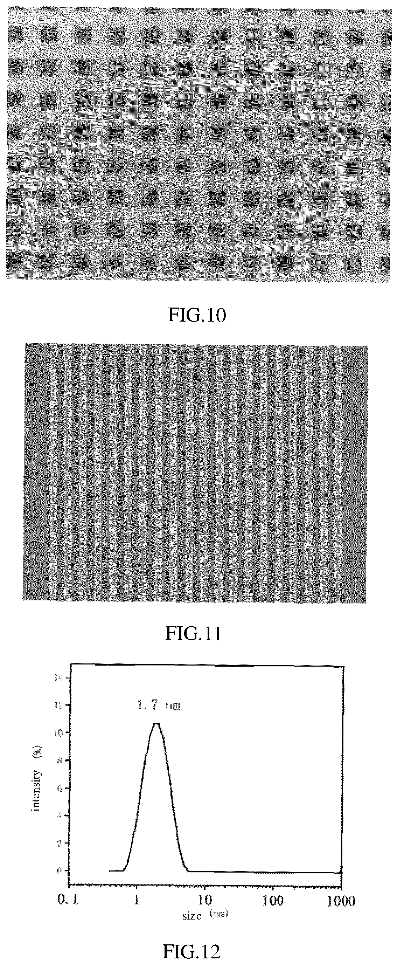

FIG. 10 shows the exposure pattern of the photoresist prepared in this example after exposure under Mid-Ultra-Violet light. It can be seen that the exposure line width is 10µm, the exposure pattern lines are clear, and the edge roughness is low, which fully meets the requirements of Mid-Ultra-Violet lithography and has higher exposure quality than the traditional CAR system. FIG. 11 shows the exposure lines with a line width of 50nm obtained by the photoresist prepared with a Zn-based organically-coordinated nanoparticle after electron beam exposure. It can be seen from the figure that the lithography pattern lines are very clear and can meet the requirements of 50nm exposure pattern, and the photoresist can be used as electron beam photoresist.

### Example 3

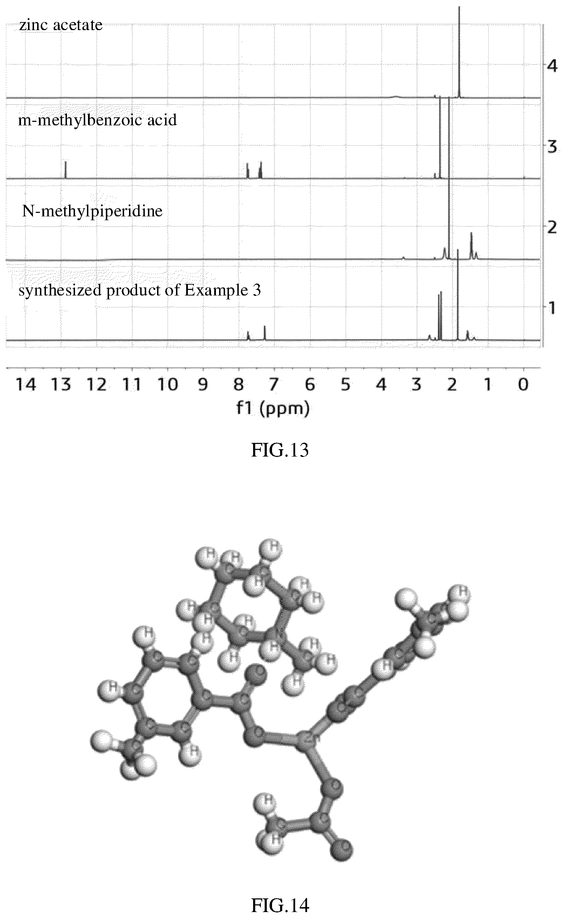

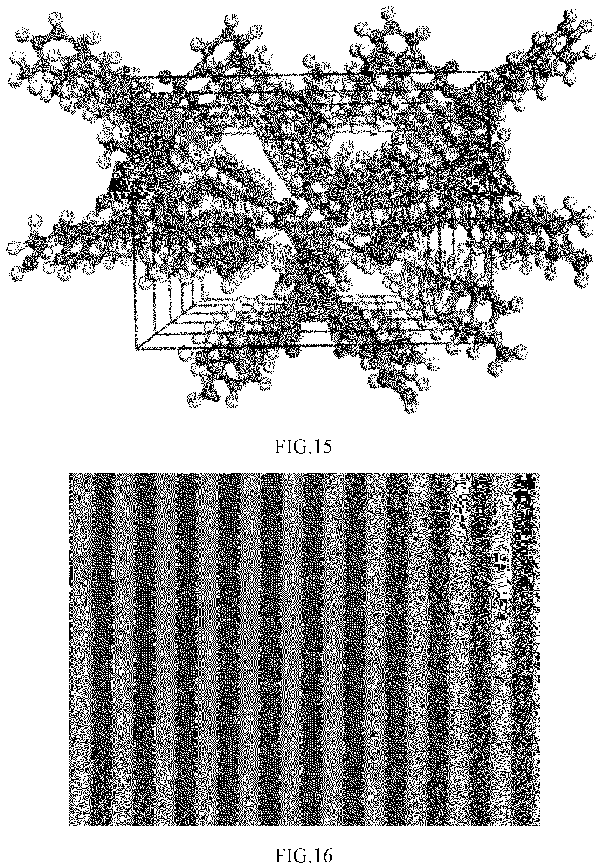

(1) Preparation of a Zn-based organically-coordinated nanoparticle: 4.936 g (36 mmol) m-methylbenzoic acid and 2.678 g (27 mmol) of N-methylpiperidine were added to a flask and mixed, 15 mL ethyl acetate was added, and the mixture was mixed and dissolved for 5 min. The resulting solution was defined as A. 3.951 g (18 mmol) zinc acetate dihydrate was added to a flask, and 30 mL ethyl acetate was added. The resulting solution was defined as B. Solution A was added dropwise to solution B in the flask and stirred at 65 °C for 16 h. After the reaction was completed, a rotary evaporator was used to evaporate at 50 °C for 40 min, and the pressure was controlled to be 40 mbar to obtain the synthesized product. An appropriate amount of the product was taken for the dynamic light scattering particle size test (DLS), and the particle size distribution curve of the product was measured (as shown in FIG. 12). As can be seen from FIG. 12, the average particle size of the suspended particles in the synthesized product is 1.7 nm, and the particle size distribution range is narrow, indicating that the particle size consistency of the nanoparticles is good. The prepared nanoparticles were subjected to nuclear magnetic resonance testing, and the hydrogen nuclear magnetic resonance (H NMR) spectrum data (see FIG. 13) were: ¹H NMR (400 MHz, DMSO-*d*₆) δ 7.96 - 7.89 (m), 7.52 - 7.43 (m), 7.40 (ddt, *J* = 8.3, 6.7, 1.4 Hz), 2.68 (d, *J* = 6.9 Hz), 2.41 (s), 1.86 (s), 1.59 (p, *J* = 5.7 Hz), 1.46 - 1.33 (m); the peaks in the N-methylpiperidine structure shift from 1.34, 1.47, 2.10, 2.22 to 1.40, 1.58, 2.39, 2.65 respectively; the peak of the methyl group in zinc acetate shifts from 1.82 to 1.86; the peak of the methyl group in m-methylbenzoic acid shifts from 2.37 to 2.33, and the peaks of the benzene ring shift from 7.39, 7.44, 7.76 to 7.40, 7.46, 7.93. In the prepared nanoparticle, each monomer is coordinated separately. After calculation, the basic structural unit of the prepared nanoparticle is Zn(CH₃C₆H₅COO)₂(CH₃COO) (CH₃C₅H₁₀N) (as shown in FIG. 14), and the formed nanoorganic structure of one-dimensional repeatedly-arranged chain is [Zn(CH₃C₆H₅COO)₂(CH₃COO)(CH₃C₅H₁₀N)]ₙ as shown in FIG. 15.
(2) Preparation of a photoresist composition containing a Zn-based organically-coordinated nanoparticle: 0.5g the above-prepared Zn-based organically-coordinated nanoparticle was taken, 0.05g N-hydroxynaphthaleneimide trifluoromethanesulfonic acid was selected, the Zn-based organically-coordinated nanoparticle and N-hydroxynaphthalene-imide trifluoromethanesulfonic acid were dissolved in 9.45g propylene glycol monomethyl ether acetate to prepare a photoresist composition containing the Zn-based organically-coordinated nanoparticle.
(3) Preparation of a photoresist coating containing a Zn-based organically-coordinated nanoparticle: the photoresist solution containing a Zn-based organically-coordinated nanoparticle prepared in step (2) was taken, and was applied on a 2-inch silicon wafer at a rotating speed of 2000 rpm for 1 min, and then the wafer was baked at 80°C for 1 min to obtain a pre-film layer of the photoresist containing the Zn-based organically-coordinated nanoparticle. The thickness of the pre-film layer was 30nm.
(4) Exposure of a photoresist coating containing a Zn-based organically-coordinated nanoparticle: Exposure was performed under 254 nm Mid-Ultra-Violet light, and exposure operation was performed by irradiating the pre-filmed layer of the substrate with the light source through a mask, so that photoresist particle agglomerates were formed in the exposed area of the pre-filmed layer. The substrate was selected from a silicon sheet, and the exposure dose of the exposure operation was 150mJ/cm². Alternatively, exposure was performed under electron beam, and the exposure dose of the exposure operation was 150µC/cm².
(5) Development: Decalin was selected as a developing agent and applied to the pre-filmed layer after exposure, so that the unexposed area of the pre-filmed layer blocked by the mask was dissolved in the developing agent, while the exposed area of the pre-filmed layer was retained on the substrate due to the formation of photoresist particle agglomerates. The development temperature was room temperature 26°C.

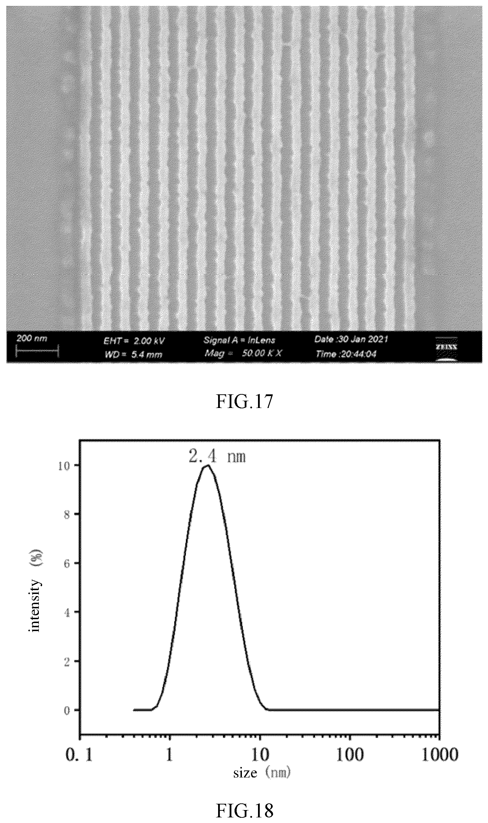

FIG. 16 shows the exposure pattern of the photoresist prepared in this example after exposure under Mid-Ultra-Violet light. It can be seen that the exposure line width is 10µm, the exposure pattern lines are clear, and the edge roughness is low, which fully meets the requirements of Mid-Ultra-Violet lithography and has higher exposure quality than the traditional CAR system. FIG. 17 shows the exposure lines with a line width of 50nm obtained by the photoresist prepared with a Zn-based organically-coordinated nanoparticle after electron beam exposure. It can be seen from the figure that the lithography pattern lines are very clear and can meet the requirements of 50nm exposure pattern, and the photoresist can be used as electron beam photoresist.

### Example 4

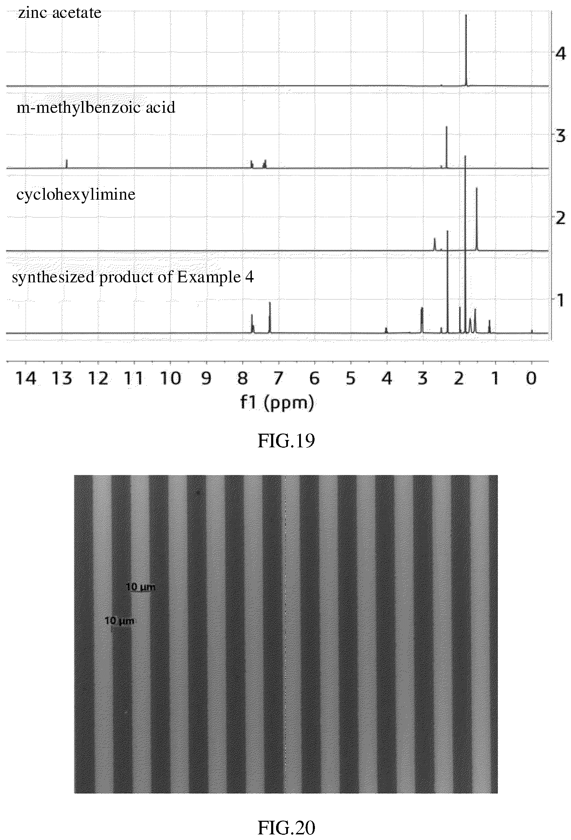

(1) Preparation of a Zn-based organically-coordinated nanoparticle: 4.936 g (36 mmol) of m-methylbenzoic acid and 2.705 g (27 mmol) of cyclohexylimine were added to a flask and mixed, 15 mL ethyl acetate was added, and the mixture was mixed and dissolved for 5 min. The resulting solution was defined as A. 3.951 g (18 mmol) zinc acetate dihydrate was added to a flask, and 30 mL ethyl acetate was added. The resulting solution was defined as B. Solution A was added dropwise to solution B in the flask and stirred at 65 °C for 16 h. After the reaction was completed, a rotary evaporator was used to evaporate at 50 °C for 40 min, and the pressure was controlled to be 40 mbar to obtain the synthesized product. An appropriate amount of the product was taken for the dynamic light scattering particle size test (DLS), and the particle size distribution curve of the product was measured (as shown in FIG. 18). As can be seen from FIG. 18, the average particle size of the suspended particles in the synthesized product is 2.4 nm, and the particle size distribution range is narrow, indicating that the particle size consistency of the nanoparticles is good. The prepared nanoparticles were subjected to nuclear magnetic resonance testing, and the H NMR spectrum data (see FIG. 19) were: ¹H NMR (400 MHz, DMSO-d₆) δ 7.75 (d, J = 1.9 Hz), 7.71 (tt, J = 4.4, 3.4 Hz), 7.30 - 7.20 (m), 3.07 - 3.00 (m), 2.33 (s), 1.84 (s), 1.75 - 1.64 (m), 1.62 - 1.51 (m). From the NMR spectrum, it can be seen that after the synthesis of nanoparticle, each monomer was coordinated separately, and peak shift occurs. The peaks in the cyclohexylimine structure shifted from 1.52 and 2.68 to 1.56, 1.70 and 3.03 respectively; the peak of the methyl group in zinc acetate shifted from 1.82 to 1.84; the peak of the methyl group in m-methylbenzoic acid shifted from 2.37 to 2.33, and the peaks of the benzene ring also shifted from 7.39, 7.44 and 7.76 to 7.25, 7.75 and 7.71. In the prepared nanoparticle, each monomer was coordinated separately. After calculation, the basic structural unit of the prepared Zn-based organically-coordinated nanoparticle was Zn(CH₃C₆H₅COO)₂(CH₃COO)(C₆H₁₄N).
(2) Preparation of a photoresist composition containing a Zn-based organically-coordinated nanoparticle: 0.5g the above-prepared Zn-based organically-coordinated nanoparticle was taken, 0.05g N-hydroxynaphthaleneimide trifluoromethanesulfonic acid was selected, the Zn-based organically-coordinated nanoparticle and N-hydroxynaphthaleneimide trifluoromethanesulfonic acid were dissolved in 9.45g propylene glycol monomethyl ether acetate to prepare a photoresist composition containing the Zn-based organically-coordinated nanoparticle.
(3) Preparation of a photoresist coating containing a Zn-based organically-coordinated nanoparticle: the photoresist solution containing a Zn-based organically-coordinated nanoparticle prepared in step (2) was taken, and was applied on a 2-inch silicon wafer at a speed of 2000 rpm for 1 min, and then the wafer was baked at 80°C for 1 min to obtain a pre-film layer of the photoresist containing the Zn-based organically-coordinated nanoparticle, the thickness of the pre-film layer was 30nm.
(4) Exposure of a photoresist coating containing a Zn-based organically-coordinated nanoparticle: Exposure was performed under 254 nm Mid-Ultra-Violet light, and exposure operation was performed by irradiating the pre-filmed layer of the substrate with the light source through a mask, so that photoresist particle agglomerates were formed in the exposed area of the pre-filmed layer. The substrate was selected from a silicon sheet, and the exposure dose of the exposure operation was 150 mJ/cm². Alternatively, exposure was performed under electron beam, and the exposure dose of the exposure operation was 200 µC/cm².
(5) Development: Decalin was selected as the developing agent and applied to the pre-filmed layer after exposure, so that the unexposed area on the pre-filmed layer blocked by the mask was dissolved in the developing agent, while the exposed area of the pre-filmed layer was retained on the substrate due to the formation of photoresist particle agglomerates. The development temperature was room temperature 26°C.

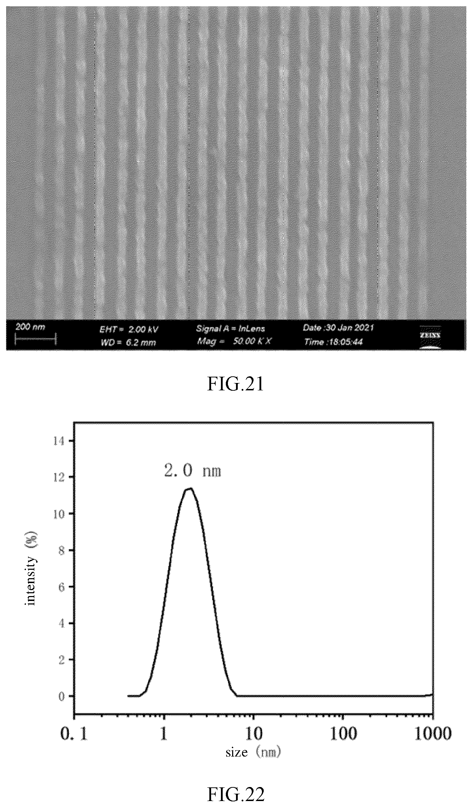

FIG. 20 shows the exposure pattern of the photoresist prepared in this example after exposure under Mid-Ultra-Violet light. It can be seen that the exposure line width is 10µm, the exposure pattern lines are clear, and the edge roughness is low, which fully meets the requirements of Mid-Ultra-Violet lithography and has higher exposure quality than the traditional CAR system. FIG. 21 shows the exposure lines with a line width of 50nm obtained by the photoresist prepared with a Zn-based organically-coordinated nanoparticle after electron beam exposure. It can be seen from the figure that the lithography pattern lines are very clear and can meet the requirements of 50nm exposure pattern, and the photoresist can be used as electron beam photoresist.

### Example 5

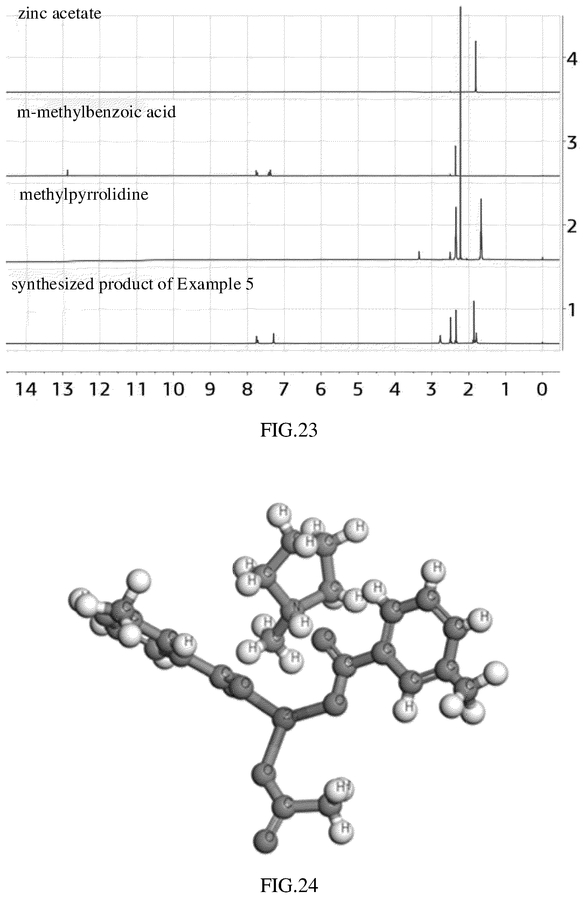

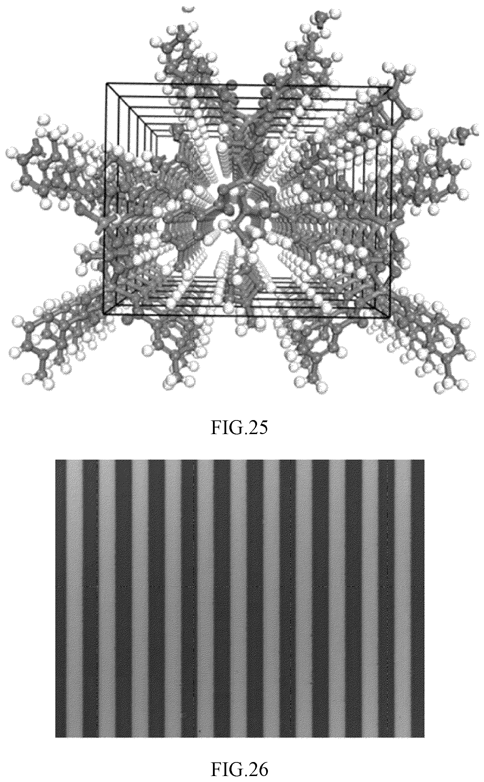

(1) Preparation of a Zn-based organically-coordinated nanoparticle: 4.936 g (36 mmol) m-methylbenzoic acid and 2.299 g (27 mmol) N-methylpyrrolidine were added to a flask and mixed, 15 mL ethyl acetate was added, and the mixture was mixed and dissolved for 5 min. The resulting solution was defined as A. 3.951 g (18 mmol) zinc acetate dihydrate was added to a flask, and 30 mL ethyl acetate was added. The resulting solution was defined as B. Solution A was added dropwise to solution B in the flask and stirred at 65 °C for 16 h. After the reaction was completed, a rotary evaporator was used to evaporate at 50 °C for 40 min, and the pressure was controlled to be 40 mbar to obtain the synthesized product. An appropriate amount of the product was taken for the dynamic light scattering particle size test (DLS), and the particle size distribution curve of the product was measured (as shown in FIG. 22). As can be seen from FIG. 22, the average particle size of the suspended particles in the synthesized product is 2.0 nm, and the particle size distribution range is narrow, and the particle size consistency of the nanoparticles is good. The prepared nanoparticles were subjected to nuclear magnetic resonance testing, and the H NMR spectrum data (see FIG. 23) were: ¹H NMR (400 MHz, DMSO-*d*₆) δ 7.75 (s), 7.72 (t, *J* = 4.7 Hz), 7.29 (d, *J* = 4.7 Hz), 2.77 (d, *J* = 6.5 Hz), 2.50 - 2.42 (m), 2.34 (s), 1.86 (s), 1.84 - 1.75 (m); It can be seen from the NMR spectrum that after the synthesis of nanoparticles, each monomer was coordinated separately, and peak shift occurs. The peaks in the methylpyrrolidine structure shifted from 1.67, 2.22 and 2.34 to 1.80, 2.46 and 2.77 respectively; the peak of the methyl group in zinc acetate shifted from 1.82 to 1.86; the peak of the methyl group in m-methylbenzoic acid is shifted from 2.35 to 2.34, and the peak of the benzene ring is also shifted from 7.39, 7.44 and 7.76 to 7.29, 7.72 and 7.75. In the prepared nanoparticle, each monomer was coordinated separately. After calculation, the basic structural unit of the prepared nanoparticle was Zn(CH₃C₆H₅COO)₂(CH₃COO) (CH₃C₄H₈N)H (see FIG. 24), and the formed one-dimensional repeatedly-arranged chain nano organic structure is shown in FIG. 25.
(2) Preparation of a photoresist composition containing a Zn-based organically-coordinated nanoparticle: 0.5g the above-prepared Zn-based organically-coordinated nanoparticle was taken, 0.05g N-hydroxynaphthaleneimide trifluoromethanesulfonic acid was selected, the Zn-based organically-coordinated nanoparticle and N-hydroxynaphthaleneimide trifluoromethanesulfonic acid were dissolved in 9.45g propylene glycol monomethyl ether acetate to prepare a photoresist composition containing the Zn-based organically-coordinated nanoparticle.
(3) Preparation of a photoresist coating containing a Zn-based organically-coordinated nanoparticle: the photoresist solution containing a Zn-based organically-coordinated nanoparticle prepared in step (2) was taken, and was applied on a 2-inch silicon wafer at a speed of 2000 rpm for 1 min, and then the wafer was baked at 80°C for 1 min to obtain a pre-film layer of the photoresist containing the Zn-based organically-coordinated nanoparticle, the thickness of the pre-film layer was 30nm.
(4) Exposure of a photoresist coating containing a Zn-based organically-coordinated nanoparticle: Exposure was performed under 254 nm Mid-Ultra-Violet light, and exposure operation was performed by irradiating the pre-filmed layer of the substrate with the light source through a mask, so that photoresist particle agglomerates were formed in the exposed area of the pre-filmed layer. The substrate was selected from a silicon sheet, and the exposure dose of the exposure operation was 150 mJ/cm². Alternatively, exposure was performed under electron beam, and the exposure dose of the exposure operation was 270 µC/cm².
(5) Development: Decalin was selected as a developing agent and applied to the pre-filmed layer after exposure, so that the unexposed area of the pre-filmed layer blocked by the mask was dissolved in the developing agent, while the exposed area of the pre-filmed layer was retained on the substrate due to the formation of photoresist particle agglomerates. The development temperature was room temperature 26°C.

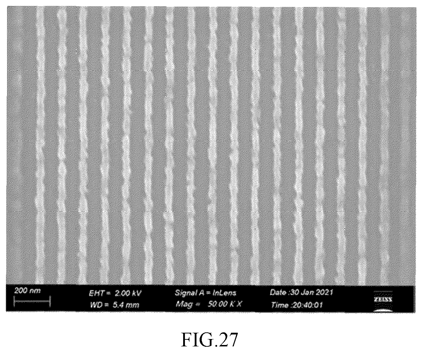

FIG. 26 shows the exposure pattern of the photoresist prepared in this example after exposure under Mid-Ultra-Violet light. It can be seen that the exposure line width is 10µm, the exposure pattern lines are clear, and the edge roughness is low, which fully meets the requirements of Mid-Ultra-Violet lithography and has higher exposure quality than the traditional CAR system. FIG. 27 shows the exposure lines with a line width of 50nm obtained by the photoresist prepared with a Zn-based organically-coordinated nanoparticle after electron beam exposure. It can be seen from the figure that the lithography pattern lines are very clear and can meet the requirements of 50nm exposure pattern, and the photoresist can be used as electron beam photoresist.

**Table 1 Characteristics of Zn-based organically-coordinated nanoparticles prepared in Examples 1-5 of the present invention**

| EXAMPL E | Raw Material | | | General structure formula of Zn-based organically-coordinated nanoparticle | Particle size(nm) |
|---|---|---|---|---|---|
| | First organic ligand | Second organic ligand | Metal salt | | |
| 1 | Benzoic acid | N-methylpiper idine | Zinc acetate dihydrate | [Zn(C₆H₅COO)₂(CH₃COO)(CH₃C₅ H₁₀N)H]ₙ | 1.5 |
| 2 | Benzoic acid | N-methylpyrro lidine | N-methylpyrroli dine | [Zn(C₆H₅COO)₂(CH₃COO)(CH₃C₄ H₈N)]ₙ | 1.9 |
| 3 | m-methylbenz oic acid | N-methylpiper idine | Zinc acetate dihydrate | [Zn(CH₃C₆H₅COO)₂(CH₃COO)(C H₃C₅H₁₀N)ₙ. | 1.7 |
| 4 | m-methylbenz oic acid | cyclohexyl imine | Zinc acetate dihydrate | [Zn(CH₃C₆H₅COO)₂(CH₃COO)(C₆ H₁₄N)]ₙ | 2.4 |
| 5 | m-methylbenz oic acid | N-methylpyrro lidine | Zinc acetate dihydrate | [Zn(CH₃C₆H₅COO)₂(CH₃COO)(C H₃C₄H₈N)H]ₙ | 2.0 |

**Table 2 Lithographic performance of photoresist compositions containing Zn-based organically-coordinated nanoparticle prepared in Examples 1-5 of the present invention**

| Exam ple | Zn-based organically-coordinated nanoparticle | Exposure light source | Exposure dose(mJ/c m²)₎/ (µC/cm²) | Line width | whether meet the clarity requireme nts |
|---|---|---|---|---|---|
| 1 | [Zn(C₆H₅COO)₂(CH₃COO)(CH₃C₅H₁₀N)H]ₙ | 254nm Mid-UV | 150 | 10µm | ✔ |
| | | Electron beam | 190 | 50nm | ✔ |
| 2 | [Zn(C₆H₅COO)₂(CH₃COO)(CH₃C₄HgN)]ₙ | 254nm Mid-UV | 150 | 10µm | ✔ |
| | | Electron beam | 190 | 50nm | ✔ |
| 3 | [Zn(CH₃C₆H₅COO)₂(CH₃COO)(CH₃C₅H₁₁N )]ₙ | 254nm mid-UV | 150 | 10µm | ✔ |
| | | Electron beam | 150 | 50nm | ✔ |
| 4 | [Zn(CH₃C₆H₅COO)₂(CH₃COO)(C₆H₁₄N)]ₙ | 254nm Mid-UV | 150 | 10µm | ✔ |
| | | Electron beam | 200 | 50nm | ✔ |
| 5 | [Zn(CH₃C₆H₅COO)₂(CH₃COO)(CH₃C₄H₈N) H]ₙ | 254nm Mid-UV | 150 | 10µm | ✔ |
| | | Electron beam | 270 | 50nm | ✔ |

At present, the photoresists produced by domestic enterprises engaged in the research and development as well as industrialization of semiconductor photoresists are mostly used in integrated circuit processes above 350nm, while ArF photoresists used in 193nm process are still in the primary stage, and high-end ArF photoresists are basically dependent on imports. Therefore, when the Zn-based organically-coordinated nanoparticle provided by the present invention may be used as photoresist materials for lithography, better pattern resolution can be obtained compared with the existing technology, which is a major step forward in the autonomy of photoresists.

In addition, compared with polymer photoresists and molecular glass photoresists, the presence of metal elements makes the photoresist of the present invention have better etching resistance.

The technical features of the above-mentioned embodiments can be combined arbitrarily. In order to make the description concise, all possible combinations of the technical features in the above-mentioned embodiments are not described. However, as long as there is no contradiction in the combination of these technical features, they should be considered as the scope of this specification.

The above-mentioned embodiments only express several implementation methods of the present invention, and the description is relatively specific and detailed, but it cannot be understood as a limitation on the scope of the invention patent. It should be pointed out that for ordinary technicians in this field, several deformations and improvements can be made without departing from the concept of the present invention, which all belong to the protection scope of the present invention. Therefore, the protection scope of the patent of the present invention shall be based on the attached claims.

## Claims

1. A Zn-based organically-coordinated nanoparticle, wherein the nanoparticle is a metal-organic one-dimensional repeatedly-arranged chain structure with a structural general formula of [ZnX₂(CH₃COO)Y]ₙ, wherein X is selected from benzoate or m-methylbenzoate; Y is selected from organic amine ligands; the size of the nanoparticle is from 1nm to 4nm; n is a degree of polymerization, which is greater than or equal to 1; and the organic amine ligand is selected from N-methylpiperidine, N-methylpyrrolidine, cyclohexylimine or methylpyrrolidine.

2. A method for preparing a Zn-based organically-coordinated nanoparticle, comprising the following steps:
(1) mixing a metallic zinc salt with an organic solvent to obtain a solution containing the metallic zinc salt;
(2) mixing the solution containing the metallic zinc salt with a first organic ligand and a second organic ligand, and heating and stirring the mixture to perform reaction therebetween;
(3) removing the residual solvent in the product after the reaction.

3. The method according to claim 2, wherein the first organic ligand is benzoic acid or m-methylbenzoic acid, and the second organic ligand is selected from N-methylpiperidine, N-methylpyrrolidine, cyclohexylimine or methylpyrrolidine.

4. The method according to claim 2, wherein the molar ratio of the metallic zinc salt, the first organic ligand and the second organic ligand is (0.2-1):(0.4-1):(0.3-1).

5. The method according to claim 2, wherein the molar ratio of the metallic zinc salt, the first organic ligand and the second organic ligand is 1:(3-5):(2-5).

6. The method according to claim 2, wherein in step (2), the temperature range of the heating and stirring is from 50°C to 80°C, and the period is from 10h to 40h.

7. The method according to claim 2, wherein in step (3), the method for removing the solvent is vacuum rotary evaporation, in which the temperature is from 20°C to 80°C, the pressure of the vacuum rotary evaporation is from 20mbar to 60mbar, and the period of the vacuum rotary evaporation is from 30 min to 60 min.

8. A Zn-based organically-coordinated nanoparticle, obtained by the method according to any one of claims 2 to 7.

9. A photoresist composition containing a Zn-based organically-coordinated nanoparticle, comprising the Zn-based organically-coordinated nanoparticle according to claim 1 or 8, a photoacid agent and an organic dispersing solvent; wherein the mass percentage of the Zn-based organically-coordinated nanoparticle is from 3% to 20%, and the mass percentage of the photoacid agent is from 5% to 10%.

10. The photoresist composition according to claim 9, wherein the photoacid agent is any one or more selected from N-hydroxynaphthalimide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid; the organic dispersing solvent is any one or more selected from ethyl acetate, butyl acetate, propylene glycol monoethyl ether acetate, propylene glycol methyl ether acetate, 1-ethoxy-2-propanol, methanol, ethanol, and propanol.

11. A method for preparing a photoresist composition containing a Zn-based organically-coordinated nanoparticle, comprising:
dissolving the nanoparticle according to claim 1 or 8 with an organic dispersing solvent;
adding a photoacid agent thereto, and stirring the mixture for 5 min until dissolved completely to obtain a photoresist composition.

12. A method for patterning a photoresist, comprising the following steps:
(1) coating the photoresist composition of claim 9 or 10 on the surface of a substrate, removing the organic dispersing solvent, and forming a pre-film layer on the surface of the substrate;
(2) irradiating the pre-film layer of the substrate with a light source through a mask to perform exposure operation, so that the exposed area of the pre-film layer forms agglomerates of the photoresist particles;
(3) applying a developing agent to the pre-film layer after exposure, so that the unexposed area of the pre-film layer blocked by the mask is dissolved in the developing agent, while the exposed area of the pre-film layer is retained on the substrate due to forming agglomerates of the photoresist particles.

13. The method of claim 12, wherein the exposure condition is any one selected from Mid-Ultra-Violet, electron beam, and Extreme Ultra-Violet, the exposure dose for Ultra-Violet is 50mJ/cm²~500mJ/cm², the exposure dose for electron beam is 50µC/cm²~500µC/cm², and the thickness of the pre-film layer after removing the organic dispersing solvent is 10nm~100nm.

14. A method for forming a printed circuit board, comprising the following steps:
(1) preparing a pre-patterned sheet having a patterned photoresist layer on a substrate of silicon sheet according to the photoresist patterning method of claim 12 or 13;
(2) etching the pre-patterned sheet by dry or wet etching.
